# EUROPEAN PATENT APPLICATION

(11) **EP 4 755 174 A2**
(43) Date of publication of application: **10.06.2026**
(21) Application number: 25220287.4
(22) Date of filing: 03.12.2025
(51) Int. Cl.: A01G 7/04, A01G 9/24, F21V 5/00, F21V 19/00, G02B 19/00, H01S 5/40

(54) **LASER PLANT SUPPLEMENTARY LIGHTING DEVICE AND SUPPLEMENTARY LIGHTING METHOD**

(30) Priority: 03.12.2024 CN 202411763596; 03.12.2024 CN 202411763598; 03.12.2024 CN 202411763601
(71) Applicant: Changchun Institute of Optics, Fine Mechanics and Physics, Chinese Academy of Sciences, Jilin 130033 (CN); Jilin Changguang Jixin Technology Co., Ltd., Changchun Jilin 130033 (CN)
(72) Inventor: JIA, Peng, Changchun (CN); QIN, Li, Changchun (CN); CAO, Junsheng, Changchun (CN); CHEN, Yongyi, Changchun (CN); LIANG, Lei, Changchun (CN); WANG, Lijun, Changchun (CN)
(74) Representative: Plavsa, Olga

(57) **Abstract**

The invention concerns a laser plant supplementary lighting device (14) comprises a base (120), a light homogenizing member (101), a control device (106), a light source, a driving circuit, a communication device (7), and a sensing component; the control device is configured to generate a first reference light intensity information based on an environmental parameter information, and generate a second reference light intensity information based on a plant-related information and the environmental parameter information, and generate operating parameters of the light source based on the first reference light intensity information and the second reference light intensity information, and control the driving circuit to adjust relevant parameters of the light source based on the operating parameters. The device can comprehensively consider different growth stages of plants and environmental factors in the current environment to adjust the output of the light source in the laser plant supplementary lighting device (14), reduce the energy consumption of the entire laser plant regulation apparatus.

## Description

### TECHNICAL FIELD

The invention relates to the field of laser agricultural lighting equipment, and specifically to a laser plant supplementary lighting device and a supplementary lighting method.

### BACKGROUND

Plant supplementary lighting lamps adopt semiconductor lighting principles and are used for the auxiliary growth of food crops, flowers, vegetables, and other plants. Generally, greenhouse crops and indoor plants/flowers tend to grow poorly over time, mainly due to lack of light irradiation. Irradiation with light sources matching the spectral requirements of plants can promote their growth, increase yield, and improve crop quality. Applying plant supplementary lighting lamps to agricultural facilities such as greenhouses and conservatories can, on the one hand, solve the problem of reduced yield and quality caused by insufficient sunlight, and on the other hand, enable early marketing of greenhouse fruits and vegetables in winter, thereby achieving off-season cultivation.

Light formula is the key to plant supplementary lighting lamps; the spectral composition and irradiation intensity largely determine the impact of the supplementary lighting lamp on plant growth and ultimately affect crop yield and quality. There are two key points in plant photosynthesis, the light compensation point and the light saturation point; when the light intensity exceeds the light compensation point, the photosynthetic rate increases correspondingly with the increase of light intensity; when a certain light intensity is reached, the photosynthetic rate no longer increases with the increase of light intensity, i.e., light saturation is achieved; at this time, if the external light intensity is greater than the plant's light saturation point, the plant will not absorb more light, resulting in light waste.

Although existing plant supplementary lighting lamps have light intensity adjustment functions, they mainly rely on manual adjustment and cannot make adaptive adjustments according to environmental changes; however, ambient temperature, humidity, ambient light intensity, and other factors all affect the light absorption of plants during growth; moreover, regarding the two key points of plant photosynthesis (the light compensation point and the light saturation point), when the light intensity exceeds the light compensation point, the photosynthetic rate increases with the increase of light intensity; when a certain light intensity is reached, the photosynthetic rate no longer increases with the increase of light intensity (i.e., light saturation is achieved); at this time, if the external light intensity is greater than the plant's light saturation point, the plant will not absorb more light, leading to light waste.

According to existing research, different growth cycles of plants require different light intensities of laser in different wavelength bands for laser regulation, and it is necessary to adjust the light intensity of laser in different wavelength bands according to ambient light and plant growth stages. The regulatory effect of laser on plant physiological cycles is experimentally significant, but to prevent light waste, it is necessary to perform feedback adjustment of laser light intensity and supplement light intensity in conjunction with plant growth stages.

Laser lighting has broad application prospects in protected agriculture such as greenhouses due to its advantages of high brightness, low energy consumption, and long service life. Laser can provide specific spectra required for plant growth, promote photosynthesis, and improve crop yield and quality. At the same time, laser lighting systems are easy to control, and the light intensity and time can be adjusted according to the crop growth cycle to achieve precision agricultural management.

Existing agricultural laser lighting equipment is mainly targeted at protected agriculture scenarios, including publicly disclosed laser lamps based on lens systems, laser irradiation devices based on optical fiber transmission, scanning laser lamps, integrated laser lamps, and other devices. Although the above devices have made great progress in improving light intensity and automation, they still have various problems, specifically as follows.

External laser lamps based on beam splitters (CN104737842A) collimates the laser through a lens group and emits it to several groups of beam splitters; each prism refracts one path of laser to a light homogenizing device, thereby achieving large-area laser irradiation. However, the optical path structure of this scheme is complex, and laser will be absorbed and scattered by water vapor or dust during transmission, introducing additional light loss and reducing energy utilization efficiency.

Laser lamps based on reflectors (JPWO2016/117314A1) collimates the laser through a collimator, emits it to the reflector, and the laser is reflected to the light homogenizing device, thereby achieving laser irradiation of plants. However, this scheme also has the problems of complex optical path and high cost.

Laser irradiation devices based on optical fiber transmission (US10,966,376B2) transmit laser radiation of specific wavelengths through optical fibers to excite plant photopigments to produce predetermined physiological responses, maximize plant photosynthesis efficiency, and control photomorphogenic responses. However, this scheme requires high-precision optical fiber coupling technology and is limited by the narrow cutoff wavelength range of a single optical fiber, which cannot cover the visible light band of 400-800nm; multiple optical fiber coupling modules are required to meet the supplementary lighting needs of plants. Therefore, the technical complexity and cost are high, making it unsuitable for large-scale promotion.

Scanning laser lamps (JP5645504B2) adopt various optical components and high-precision electronic control components to control the on/off state and scanning range of the laser light source, ensuring that laser is only emitted to the area where plants are located with no laser irradiation in other areas, thereby improving the utilization efficiency of light energy and reducing energy consumption. However, in this scheme, laser devices need to be arranged above each plant, resulting in high equipment costs and making it unsuitable for large-scale greenhouse production applications.

Integrated laser lamps (CN109945079B and CN103629596B) adopt schemes such as special-shaped heat sinks to complete the development of the integrated laser lamp; however, due to the high degree of integration, the heat dissipation performance of the light source is limited, making it impossible to achieve high output power and resulting in a limited irradiation area.

Conventional supplementary lighting devices generally adopt complex optical path structures, which have the problems of complex structure and high cost; the above problems seriously affect the application prospects of supplementary lighting devices in large-scale protected agricultural production.

### SUMMARY

To solve the above-mentioned problems, the invention provides a laser plant supplementary lighting device and a supplementary lighting method.

To address the above-mentioned technical issues, the invention provides the technical solutions that are set out in the appended set of claims.

Compared with the prior art, the above-mentioned technical solutions have the following advantages:

The laser plant regulation apparatus provided by the invention comprises a base, a light homogenizing member, a control device, a light source, a driving circuit, a communication device, and a sensing component; the control device is electrically connected to the light source, the driving circuit, the communication device, and the sensing component; the sensing component is configured to collect environmental parameter information, and the communication device is configured to acquire plant-related information; the control device is configured to generate a first reference light intensity information based on an environmental parameter information, and generate a second reference light intensity information based on a plant-related information and the environmental parameter information, and generate operating parameters of the light source based on the first reference light intensity information and the second reference light intensity information, and control the driving circuit to adjust relevant parameters of the light sources with different wavelength bands based on the operating parameters. This technical solution realizes the adjustment of relevant parameters of the light source based on environmental parameter information and plant-related information, thereby achieving the effect of adjusting the light intensities of the first wavelength band laser and the second wavelength band laser; the device can comprehensively consider different growth stages of plants and environmental factors in the current environment to adjust the output of the light source in the laser plant regulation lighting device, reduce the energy consumption of the entire laser plant regulation apparatus, better match the growth state of plants, and improve the growth rate of plants.

In addition, the distributed laser plant supplementary lighting device adopts a distributed structure design based on photoelectric separation, which reduces the design difficulty of the heat dissipation structure of the laser device and improves heat dissipation efficiency, effectively solving the problems of complex heat dissipation structure and unsatisfactory heat dissipation effect of the integrated photoelectric laser lamp; it also solves the problems of complex structure and high cost of agricultural laser supplementary lighting lamps. By using the same intelligent control component to regulate a plurality of laser devices reduces the number of sensors and circuits, effectively lowers the cost of circuits and sensors, and increases the irradiation area of a single set of equipment, thereby reducing the per mu cost of laser lamps and effectively solving the problem of high cost and the inability of laser lamps to be promoted on a large scale. The laser device adopts a free-form surface lens array (curvature 0.65-2.36) to increase the divergence angle of the laser to 60-120°; and taking advantage of the narrow spectral linewidth and long irradiation distance of the laser, each laser device can irradiate 40-60 square meters; a single set of devices, i.e., 3-4 laser devices irradiates 120-240 square meters, forming a large-area laser regulation field; this enables plants within the irradiation range of the laser field to receive coherent laser irradiation exceeding 0.1 µmol/m²/s, accelerating their photosynthesis rate, increasing nutrient accumulation, and achieving the goals of quality improvement and yield increase.

### BRIEF DESCRIPTION OF DRAWINGS

In order to provide a clearer explanation of the technical solution in the embodiments of the present invention, a brief introduction will be given to the drawings required for the description of the embodiments. It is obvious that the accompanying drawings are some embodiments of the present invention. For those skilled in the art, other drawings can be obtained based on these drawings without creative labor.
Fig. 1 is a first schematic diagram of a laser plant regulation apparatus according to an embodiment of the invention.
Fig. 2 is a second schematic diagram of a laser plant regulation apparatus according to an embodiment of the invention.
Fig. 3 is a step diagram of a laser plant regulation method according to an embodiment of the invention.
Fig. 4 is a first schematic diagram of an adaptive laser plant supplementary lighting lamp based on spectral analysis according to an embodiment of the invention.
Fig. 5 is a second schematic diagram of an adaptive laser plant supplementary lighting lamp based on spectral analysis according to an embodiment of the invention.
Fig. 6 is a step diagram of an adaptive laser plant supplementary lighting method according to an embodiment of the invention.
Fig. 7 is a top view of a distributed laser plant supplementary lighting device according to an embodiment of the invention.
Fig. 8 is a bottom view of a distributed laser plant supplementary lighting device according to an embodiment of the invention.
Fig. 9 is a structural schematic diagram of a light exit surface of a distributed laser plant supplementary lighting device according to an embodiment of the invention.
Fig. 10 is a structural schematic diagram of a laser device in a distributed laser plant supplementary lighting device according to an embodiment of the invention.
Fig. 11 is a structural schematic diagram of an intelligent control component in a distributed laser plant supplementary lighting device according to an embodiment of the invention.
Fig. 12 is a schematic diagram of an overlapping light field distribution of a distributed laser plant supplementary lighting device according to an embodiment of the invention.

### Reference Signs:

101. Light homogenizing member; 102. First light source; 103. Second light source; 104. First driving circuit; 105. Second driving circuit; 106. Control device; 11. First laser device; 111. Laser device housing; 112. Light exit panel; 113. Light homogenizing lens array; 114. Semiconductor laser; 115. Heat sink-based circuit board; 116. Laser radiator; 117. Heat dissipation backplane; 118. Laser device cable connector; 12. Second laser device; 13. Third laser device; 2. Intelligent controller; 21. Communication component; 22. Information display screen; 23. Light intensity detector; 24. Temperature detector; 25. Gas composition detector; 26. Cable interface; 27. Power supply access port; 28. Controller housing; 3. Connecting cable; 6A. First rectangular laser beam field; 6B. Second rectangular laser beam field; 6C. Third rectangular laser beam field; 7. Communication device; 8. First display device; 9. Second display device; 10. DC voltage stabilizing component; 110. Power supply device; 120. Base; 130. Preset terminal; 14. Plant supplementary lighting lamp; 15. Plant; 16. Insecticidal lamp and/or pest repellent lamp.

### DETAILED DESCRIPTION

To make the above objects, features, and advantages of the invention more comprehensible, the specific embodiments of the invention will be described in detail below with reference to the drawings.

Specific details are set forth in the following description to facilitate a full understanding of the invention. However, the invention can be implemented in various ways other than those described herein, and those skilled in the art can make similar promotions without departing from the connotation of the invention. Therefore, the invention is not limited to the specific embodiments disclosed below.

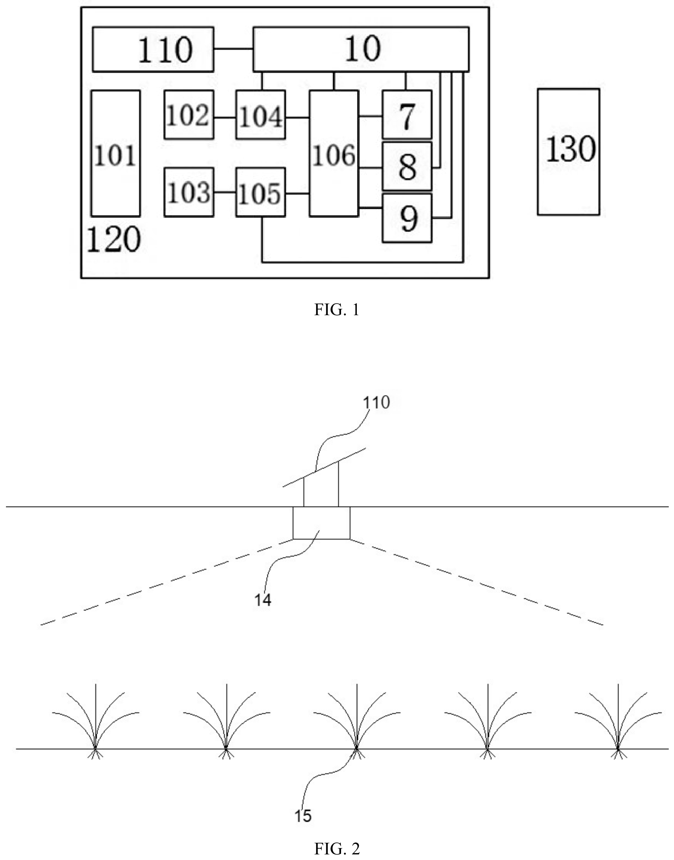

Referring to Figs. 1 and 2, in a first aspect, the present embodiment provides a laser plant regulation apparatus (plant supplementary lighting lamp 14), comprising a base 120, a light homogenizing member 101, a control device 106, a light source, a driving circuit, a communication device 7, and a sensing component; the base 120 includes an accommodating cavity and a light through-hole, wherein the light through-hole is in communication with the accommodating cavity; the light homogenizing member 101 is disposed at the light through-hole; the light source is disposed in the accommodating cavity, an output end of the light source is configured to toward the light homogenizing member 101, and the light source is configured to output a plurality of lasers with different wavelength bands; preferably, the lasers include a first wavelength band laser and a second wavelength band laser; the driving circuit is disposed in the accommodating cavity and electrically connected to the light source and the control device 106, respectively, and the driving circuit is configured to adjust relevant parameters of the light source based on the control commands of the control device 106; the communication device 7 is disposed in the accommodating cavity and electrically connected to the control device 106, and is configured to establish a communication connection with a server to obtain plant-related information; the sensing component is disposed in the accommodating cavity and electrically connected to the control device 106, and is configured to collect environmental parameter information; the control commands of the control device 106 include operating parameters of the light source, which are generated based on the plant-related information and/or the environmental parameter information.

In this embodiment, the base 120 can be understood as a supporting component for fixing other parts; specifically, the base 120 may be a housing, a frame, a stand, or the like. The base 120 includes an accommodating cavity, the control device 106, the light source, the driving circuit, and the communication device 7 can all be disposed in the accommodating cavity; the base 120 is further provided with a light through-hole in communication with the accommodating cavity, and the light homogenizing member 101 is disposed at the light through-hole; specifically, the light homogenizing member 101 may be a combination of a plurality of optical lenses or an integral structure, which is not limited in this embodiment. The light homogenizing member 101 is configured to uniformly disperse the first wavelength band laser and the second wavelength band laser output by the light source into the planting area where plants 15 are grown.

The light source is a laser, specifically, the light source may be a dual-frequency laser or a single-frequency laser; the driving circuit is electrically connected to the light source and is a semiconductor laser pulse driving circuit; the driving circuit can drive the light source to generate repetitive pulse lasers with a certain amplitude, frequency, and pulse width; the repetitive pulse lasers can increase the photosynthesis rate of plants 15 while reducing the energy consumption of the light source.

In this embodiment, the first wavelength band laser and the second wavelength band laser correspond to the light waves in the wavelength bands required for the photosynthesis of plants 15; for example, the first wavelength band may be understood as the wavelength range where red light is located, and the second wavelength band may be understood as the wavelength range where blue light is located. Specifically, the specific wavelength ranges of the first and second wavelength bands can be further set according to the type of plants 15 to meet the photosynthesis needs of different types of plants 15.

The communication device 7 varies according to the communication connection method in practical applications; for example, the communication device 7 may be an NB-IoT communication device, a Bluetooth communication device, a Star Flash communication device, a WIFI communication device, a 4G network standard communication device, or the like. Optionally, the communication device 7 may also establish a connection with a preset terminal 130 for communicating with the preset terminal 130; the preset terminal 130 may be a mobile phone, a tablet, a laptop computer, or the like, or an infrared remote controller, which is specifically adjusted according to actual needs.

The communication device 7 is configured to collect plant-related information, which refers to the relevant information of plants 15 grown in the current planting area, including the type of plants 15, the current growth stage of plants 15, and the light intensity required by plants 15 at this growth stage; specifically, the light intensity refers to the wavelength range and light intensity of light waves corresponding to the highest photosynthesis efficiency of the plants 15.

The sensing component is configured to collect environmental parameter information, which includes the temperature and humidity information of the environment and the existing light intensity in the environment.

The control commands of the control device 106 include operating parameters of the light source; herein, it can be understood that the light source and the driving circuit work together to generate the first wavelength band laser and the second wavelength band laser, so the operating parameters of the light source correspond to the adjustments of the light source and the driving circuit. The operating parameters are generated based on the plant-related information and/or the environmental parameter information, specifically meaning that the control device 106 can obtain the operating parameters of the light source according to the existing light intensity in the environment and the light intensity corresponding to the highest photosynthesis efficiency of plants 15 at the current growth stage; specifically, by calculating the difference between the light intensity required by plants 15 and the existing light intensity in the environment, the light intensities of the first wavelength band laser and the second wavelength band laser that need to be output by the light source can be obtained, and then the operating parameters of the light source can be derived through conversion.

Referring to Fig. 1, in some embodiments, the light source includes a first light source 102 and a second light source 103 arranged in parallel; the first light source 102 is configured to output the first wavelength band laser, and the second light source 103 is configured to output the second wavelength band laser; the driving circuit includes a first driving circuit 104 and a second driving circuit 105; the first driving circuit 104 is electrically connected to the first light source 102, and the second driving circuit 105 is electrically connected to the second light source 103.

In this embodiment, the light source includes the first light source 102 and the second light source 103 arranged in parallel; herein, "arranged in parallel" means arranged in parallel corresponding to the light through-hole, so that the light homogenizing member 101 can homogenize the light from both the first light source 102 and the second light source 103 simultaneously. The first light source 102 can generate laser in the first wavelength band, which is denoted as the first wavelength band laser, and the second light source 103 can generate laser in the second wavelength band, which is denoted as the second wavelength band laser. Correspondingly, the driving circuit includes the first driving circuit 104 and the second driving circuit 105; the first driving circuit 104 is connected to the first light source 102, and the second driving circuit 105 is connected to the second light source 103. The control device 106 controls the first driving circuit 104 and the second driving circuit 105 respectively to adjust the first wavelength band laser and the second wavelength band laser.

In some embodiments, the sensing component comprises at least one of a temperature sensor, a humidity sensor, a vision sensor, a spectral sensor, and a timer. In this embodiment, the temperature sensor is configured to collect the ambient temperature information of the current planting area; the humidity sensor is configured to collect the ambient humidity information of the current planting area; the vision sensor is configured to collect the image information of the current planting area, extract the image data of plants 15 in the current planting area according to the image information, and determine the current growth stage of plants 15 based on the image data of plants 15; the spectral sensor is configured to collect the ambient light information of the current planting area, which includes the light intensities of the first wavelength band and the second wavelength band in the environment.

It should be noted that the timer is used to synchronize current time data; the photosynthesis rate of plants 15 is different during the day and night, and the light intensity in the environment also differs; therefore, adding a timer facilitates the control device 106 to periodically adjust the first wavelength band laser and the second wavelength band laser according to the time data of the timer.

As a preferred embodiment, the laser plant regulation apparatus may further include a Power supply device 110 and a DC voltage stabilizing component 10; the laser plant regulation apparatus of the invention can be powered by an AC power supply or a DC power supply. When the laser plant regulation apparatus is connected to a DC power supply, the Power supply device 110 may be a lithium battery, a lead-acid battery, a solar panel, or the like. When the laser plant regulation apparatus is powered by an AC power supply, the DC voltage stabilizing component 10 can be used to convert AC power into DC power for the control device 106, the driving circuit, and the light source; Fig. 2 shows a form where the Power supply device 110 is a solar panel; it should be noted that when the Power supply device 110 is a solar panel, the Power supply device 110 should be disposed outside the base 120 and facing south; preferably, the angle between the surface of the solar panel and the horizontal plane should correspond to the local latitude.

As another preferred embodiment, the laser plant regulation apparatus may further include a first display device 8 and a second display device 9; the first display device 8 and the second display device 9 are disposed outside the base 120 and both electrically connected to the control device 106; the first display device 8 is configured to display current information of the first wavelength band laser, including the wavelength range, amplitude, frequency, pulse, etc., of the first wavelength band laser; the second display device 9 is configured to display current information of the second wavelength band laser, including the wavelength range, amplitude, frequency, pulse, etc., of the second wavelength band laser; this way, users can directly check the supplementary lighting status of the supplementary lighting device.

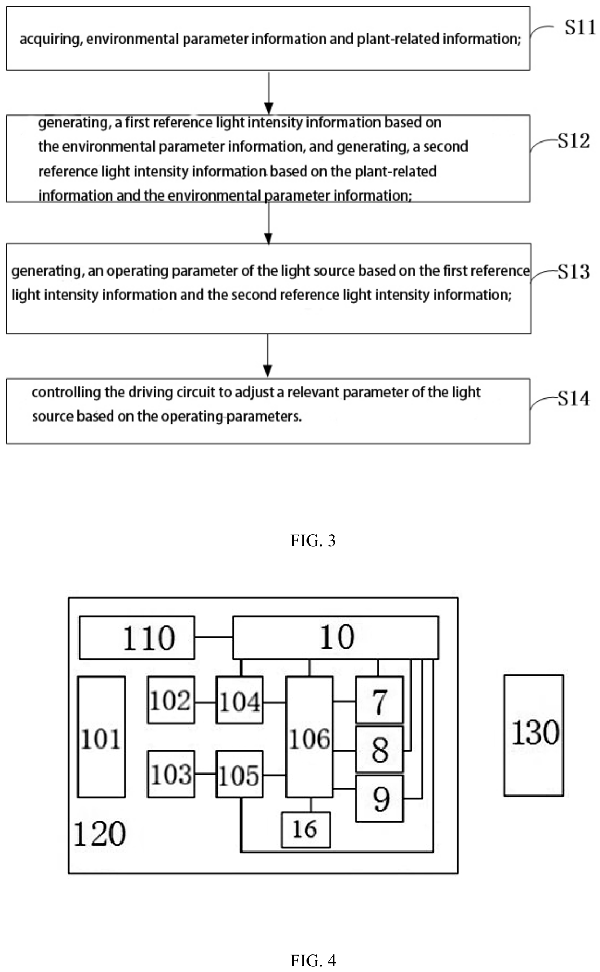

Referring to Fig. 3, in a second aspect, this embodiment further provides a laser plant regulation method, being applicable to the laser plant regulation apparatus according to the first aspect; the method includes the following steps.

S11: acquiring, environmental parameter information and plant-related information, wherein the environmental parameter information includes at least one of a temperature information, a humidity information, a light information, and a time information; the plant-related information includes a growth type, a growth habit, and a growth status of currently planted plant.

S12: generating, a first reference light intensity information based on the environmental parameter information, and generating, a second reference light intensity information based on the plant-related information and the environmental parameter information.

S13: generating, an operating parameter of the light source based on the first reference light intensity information and the second reference light intensity information.

S14: controlling, the driving circuit to adjust a relevant parameter of the light source with a plurality with different wavelength bands based on the operating parameter.

In this embodiment, the environmental parameter information refers to the temperature information, humidity information, light information, and time information of the environment where the current planting area is located; specifically, the light information includes the light intensity of the first wavelength band and the second wavelength band in the environment; the time information is current time data (e.g., 8:00 AM, 10:00 PM, etc.).

It should be noted that the growth type of currently planted plants can be understood as the category of the plants; the growth habits can be understood as various information of this category of plants during growth, including requirements for ambient temperature and humidity, and the light intensity required for the highest photosynthetic efficiency at different growth stages; for ease of understanding, the photon flux density of different spectra required for the highest photosynthetic efficiency at different growth stages is denoted as "growth light"; the growth status can be understood as the real-time growth state of the currently planted plants; for example, the growth habits include temperature and humidity requirements, and the light intensity required for photosynthesis corresponding to the seedling stage, seedling establishment stage, growth stage, flowering stage, and fruiting stage of the plants; the growth status refers to the current growth stage of the plants (i.e., one of the seedling stage, seedling establishment stage, growth stage, flowering stage, and fruiting stage).

It should be emphasized that the principle of the plant supplementary lighting lamp is as follows: calculate the light intensity difference between the light intensity required for plant photosynthesis and the existing light intensity in the current environment; this light intensity difference is the light intensity that the plant supplementary lighting lamp needs to provide to meet the light intensity requirements for plant growth.

Based on this principle, this embodiment generates a first reference light intensity information based on an environmental parameter information, and further generate a second reference light intensity information based on a plant-related information and the environmental parameter information, and generate operating parameters of the light source based on the first reference light intensity information and the second reference light intensity information, and control the driving circuit to adjust relevant parameters of the light source with a plurality with different wavelength bands based on the operating parameters. Specifically meaning that the control device can obtain the operating parameters of the light source according to the existing light intensity in the environment and the light intensity corresponding to the highest photosynthesis efficiency of plants at the current growth stage; specifically, by calculating the difference between the light intensity required by plants and the existing light intensity in the environment, the light intensities of the first wavelength band laser and the second wavelength band laser that need to be output by the light source can be obtained, and then the operating parameters of the light source can be derived through conversion; and the relevant parameters of the light source are adjusted based on the operating parameters.

This embodiment comprehensively considers plant-related information and environmental parameter information to obtain the first reference light intensity information and the second reference light intensity information, then obtains the operating parameters of the light source based on the first reference light intensity information and the second reference light intensity information, and finally achieves the adjustment of the light intensities of the first wavelength band laser and the second wavelength band laser. Compared with the existing adjustment principle of plant supplementary lighting lamps that directly use ambient light as a reference, this embodiment further considers the plant type and the light intensity required for optimal photosynthesis at different growth stages; at the same time, it also takes into account the impact of ambient temperature and humidity on plant photosynthetic efficiency and the wavelength loss of the first and second wavelength band lasers during transmission, thereby realizing the adjustment of the first and second wavelength band lasers; this enables the entire laser plant regulation apparatus to have more superior adaptive adjustment, further optimizes light source control, achieves a good plant supplementary lighting effect, and reduces energy consumption.

In some embodiments, the first reference light intensity information includes an intensity variation value of ambient light within a preset period; the second reference light intensity information includes an intensity variation value of a growth light within a preset period; the environmental parameter information includes a time information.

Generating, an operating parameter of the light source based on the first reference light intensity information and the second reference light intensity information, comprises:
Obtaining, an intensity value of the ambient light in a current first reference light intensity information based on the current time information, and obtaining, an intensity value of the growth light in a current second reference light intensity information based on the current time information.

Calculating, a difference between the intensity value of the ambient light and the intensity value of the growth light.

Generating, an intensity value of the first wavelength band laser and an intensity value of the second wavelength band laser based on the difference.

Calculating an operating parameter of the lasers with different wavelength bands of the light source based on the intensity value of the first wavelength band laser and the intensity value of the second wavelength band laser.

In this embodiment, the first reference light intensity information can be understood as a discrete point data set, which includes intensity variation values of ambient light within a preset period. Similarly, the second reference light intensity information can also be understood as another independent discrete point data set, which includes intensity variation values of growth light within the preset period.

In this embodiment, the preset period range is preferably 24 hours, i.e., a full day is used as the minimum measurement unit. This method is more in line with the growth habits of plants and the variation cycle of ambient light in the planting area.

Specifically, the intensity value of ambient light in the current first reference light intensity information and the intensity value of growth light in the current second reference light intensity information are obtained based on the current time information; the difference between the intensity value of ambient light and the intensity value of growth light corresponding to this time information is calculated, and the intensity value of the first wavelength band laser and the intensity value of the second wavelength band laser are generated based on the difference. It should be noted that the difference includes the light intensity difference of the first wavelength band and the light intensity difference of the second wavelength band, which also correspond to the intensity value of the first wavelength band laser and the intensity value of the second wavelength band laser in the laser plant regulation apparatus.

In some embodiments, the environmental parameter information includes temperature information and humidity information.

Generating, a second reference light intensity information based on the plant-related information and the environmental parameter information, further comprises:
acquiring, a plant-related information, and generating, a first growth light reference value of a current plant in a current growth stage based on the plant-related information;
acquiring, current vision sensor information, current timer information, current temperature information, and current humidity information, and generating, a second growth light reference value of the plant in the current growth stage based on the current vision sensor information, the current timer information, the current temperature information, and the current humidity information; and
generating, a second reference light intensity information based on the first growth light reference value and the second growth light reference value.

It should be noted that temperature information affects the efficiency of photosynthesis, and humidity information affects the energy loss of light in the first wavelength band and the second wavelength band during transmission in the air. Based on this, the generation of the second reference light intensity information needs to comprehensively consider the impact of current temperature on photosynthetic efficiency and the intensity loss of ambient light caused by current humidity.

In this embodiment, the first growth light reference value refers to the growth light corresponding to the highest photosynthetic efficiency of the plant under ideal environmental conditions, and the second growth light reference value refers to the growth light corresponding to the highest photosynthetic efficiency of the current plant under actual environmental conditions.

The second reference light intensity information is generated based on the first growth light reference value and the second growth light reference value; specifically, weighted calculation can be performed on the first growth light reference value and the second growth light reference value (for example, a plant requires light with a wavelength of 660 nm and 450 nm for growth, and the weight ratio of the photon flux densities corresponding to the two wavelengths is 3:7; then, the second reference light intensity information can be generated based on the corresponding weight ratio of the first growth light reference value and the second growth light reference value), thereby obtaining the second reference light intensity information.

This embodiment comprehensively considers the impact of current environmental humidity information and temperature information on the second reference light intensity information; the calculated second reference light intensity information is more in line with the actual environment, thereby realizing precise adjustment of the supplementary lighting intensity of the laser plant regulation apparatus.

In some embodiments, calculating, a difference between the intensity value of the ambient light and the intensity value of the growth light, comprises:
acquiring the intensity value of ambient light within the first wavelength band range in the ambient light, denoted as a first intensity value; acquiring the intensity value of growth light within the first wavelength band range in the growth light, denoted as a second intensity value; performing a subtraction operation between the first intensity value and the second intensity value to obtain a first wavelength band difference; and
acquiring the intensity value of ambient light within the second wavelength band range in the ambient light, denoted as a third initial value; acquiring the intensity value of growth light within the second wavelength band range in the growth light, denoted as a fourth initial value; performing a subtraction operation between the third initial value and the fourth initial value to obtain a second wavelength band difference.

Generating, an intensity value of the first wavelength band laser and an intensity value of the second wavelength band laser based on the difference, comprises:
using a first wavelength band difference as an intensity value of the first wavelength band laser; and
using a second wavelength band difference as an intensity value of the second wavelength band laser.

In this embodiment, based on the principle of photosynthesis, plants have the highest photosynthetic efficiency in the first wavelength band range and the second wavelength band range; therefore, the laser plant regulation apparatus is mainly used to adjust the light intensity corresponding to the first wavelength band range and the second wavelength band range. Further, acquiring the intensity value of ambient light within the first wavelength band range in the ambient light, denoted as a first intensity value; acquiring the intensity value of growth light within the first wavelength band range in the growth light, denoted as a second intensity value; performing a subtraction operation between the first intensity value and the second intensity value to obtain a first wavelength band difference; and acquiring the intensity value of ambient light within the second wavelength band range in the ambient light, denoted as a third initial value; acquiring the intensity value of growth light within the second wavelength band range in the growth light, denoted as a fourth initial value; performing a subtraction operation between the third initial value and the fourth initial value to obtain a second wavelength band difference. Correspondingly, the first wavelength band difference is the intensity value of the first wavelength band laser in the laser plant regulation apparatus, and the second wavelength band difference is the intensity value of the second wavelength band laser in the laser plant regulation apparatus.

In some embodiments, the preset period range is 24 hours.

In some embodiments, the operating parameters of the light source include laser output power during continuous output, or peak power, pulse width, and repetition frequency during pulse output.

In a third aspect, this embodiment further provides a computer-readable storage medium storing computer program instructions, when computer program instructions are executed by a processor, implement the method according to the second aspect.

In the above-mentioned technical solution, the laser plant regulation apparatus provided by the invention comprises a base, a light homogenizing member, a control device, a light source, a driving circuit, a communication device, and a sensing component; the control device is electrically connected to the light source, the driving circuit, the communication device, and the sensing component; the sensing component is configured to collect environmental parameter information, and the communication device is configured to acquire plant-related information; the control device is configured to generate a first reference light intensity information based on an environmental parameter information, and generate a second reference light intensity information based on a plant-related information and the environmental parameter information, and generate operating parameters of the light source based on the first reference light intensity information and the second reference light intensity information, and control the driving circuit to adjust relevant parameters of the light sources with different wavelength bands based on the operating parameters. This technical solution realizes the adjustment of relevant parameters of the light source based on environmental parameter information and plant-related information, thereby achieving the effect of adjusting the light intensities of the first wavelength band laser and the second wavelength band laser; the device can comprehensively consider different growth stages of plants and environmental factors in the current environment to adjust the output of the light source in the laser plant regulation lighting device, reduce the energy consumption of the entire laser plant regulation apparatus, better match the growth state of plants, and improve the growth rate of plants.

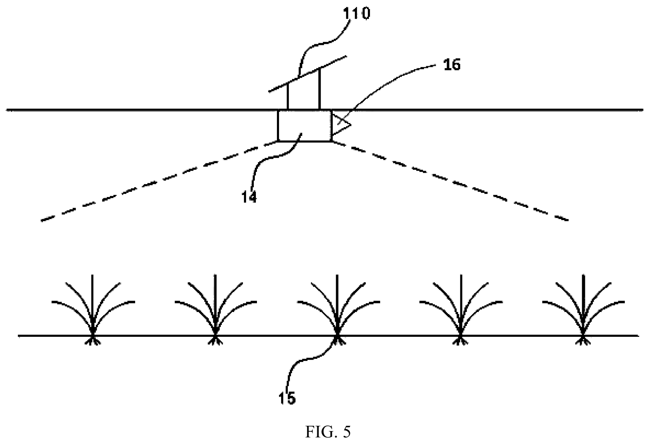

Referring to Figs. 4 and 5, in a fourth aspect, this embodiment provides an adaptive laser plant supplementary lighting lamp 14 based on spectral analysis, disposed in a plant planting area; the lamp 14 includes a base 120, and a light source component, a light homogenizing component, a control component, and a spectral analysis component disposed on the base 120; the light source component comprises a plurality of light sources arranged in parallel, which emit lasers with different wavelength bands; one of the light sources is denoted as a first light source 102, and another is denoted as a second light source 103; the first light source 102 is configured to emit a first wavelength band laser, and the second light source 103 is configured to emit a second wavelength band laser; the light homogenizing component includes a light homogenizing member 101 disposed at the output ends of the first light source 102 and the second light source 103, which is configured to homogenize the first wavelength band laser and the second wavelength band laser and then project them onto the plant planting area; the spectral analysis component comprises a spectral collection end and a spectral analysis device, and the spectral collection end electrically connected to the spectral analysis device and arranged facing the external environment; the spectral collection end is configured to collect environmental spectra within a preset wavelength band range (i.e., the spectral band utilizable by plants) in ambient light, where the environmental spectra include a first wavelength band ambient light and a second wavelength band ambient light; the spectral analysis device is configured to calculate a first ratio value between the first wavelength band ambient light and the second wavelength band ambient light; the control component includes a control device 106 electrically connected to the first light source 102, the second light source 103, the spectral analysis device, and the spectral collection end; the control device 106 is configured to calculate a second ratio value between the first wavelength band laser and the second wavelength band laser based on the first ratio value, and adjust the operating parameters of the first light source 102 and the second light source 103 based on the second ratio value.

In this embodiment, the base 120 can be understood as a supporting component for fixing other parts; specifically, the base 120 may be a housing, a frame, a stand, or the like. The base 120 includes an accommodating cavity, the control device 106, the light source, the driving circuit, and the communication device 7 can all be disposed in the accommodating cavity; the base 120 is further provided with a light through-hole in communication with the accommodating cavity, and the light homogenizing member 101 is disposed at the light through-hole; specifically, the light homogenizing member 101 may be a combination of a plurality of optical lenses or an integral structure, which is not limited in this embodiment. The light homogenizing member 101 is configured to uniformly disperse the first wavelength band laser and the second wavelength band laser output by the light source into the planting area where plants 15 are grown.

The light source is a laser; specifically, since light of different wavelengths has different effects on the photosynthesis of plants 15, and blue light (400-520nm) and red light (610-720nm) contribute the most to photosynthesis, this embodiment preferably includes lasers with red and blue wavelengths; thus, the first wavelength band may be understood as the range where red light is located, and the second wavelength band as the range where blue light is located. Specifically, the specific wavelength ranges of the first and second wavelength bands can be further set according to the type of plants 15 to meet the photosynthesis needs of different types of plants 15.

In this embodiment, the light source includes the first light source 102 and the second light source 103 arranged in parallel; herein, "arranged in parallel" means arranged in parallel corresponding to the light homogenizing member 101, so that the light homogenizing member 101 can homogenize the light from both the first light source 102 and the second light source 103 simultaneously. The first light source 102 can generate laser in the first wavelength band, which is denoted as the first wavelength band laser, and the second light source 103 can generate laser in the second wavelength band, which is denoted as the second wavelength band laser.

The spectral analysis component includes a spectral analysis device and a spectral collection end; preferably, the spectral analysis component may be an integral structure, such as a detector (specifically, a CCD detector), where the spectral collection end serves as the detection end of the detector, and the spectral analysis device also is an analysis and calculation module integrated in the detector. The spectral analysis device is capable of calculating the first ratio value between the first wavelength band ambient light and the second wavelength band ambient light, i.e., the first ratio value = photon flux density of the first wavelength band ambient light : photon flux density of the second wavelength band ambient light.

It should be emphasized that the principle of the plant supplementary lighting lamp 14 is as follows: calculate the light intensity difference between the light intensity required for photosynthesis of plant 15 and the existing light intensity in the current environment; this light intensity difference is the light intensity that the plant supplementary lighting lamp 14 needs to provide to meet the light intensity requirements for growth of plant 15. Based on this, the control device 106 is configured to calculate the second ratio value between the first wavelength band laser and the second wavelength band laser based on the first ratio value, and adjust the operating parameters of the first light source 102 and the second light source 103 based on the second ratio value; specifically, the control device 106 may pre-acquire the preset ratio value between the first wavelength band light and the second wavelength band light required by the current plants 15 at their current growth stage; then, combined with the first ratio value corresponding to the existing ambient light, calculations can be performed to obtain the second ratio value corresponding to the first wavelength band laser and the second wavelength band laser, and the operating parameters of the first light source 102 and the second light source 103 are adjusted based on the second ratio value. For ease of description, the light in the first wavelength band and the second wavelength band are abbreviated as red-blue light. For example, for a certain crop, the desired intensity ratio of red-blue light irradiation is 5M:1M (where M is the optical power per unit area); if the actual measured ratio of red-blue light in the ambient light is 2.5M:0.5M, the supplementary lighting lamp needs to output red-blue light at an intensity ratio of 2.5M:0.5M.

It should be noted that the light formula is the key to the plant supplementary lighting lamp 14; the spectral composition and irradiation intensity largely determine the impact of the supplementary lighting lamp on the growth of plants 15 and ultimately affect crop yield and quality. By monitoring the intensity of red-blue light components in the ambient light, and then dynamically adjusting the output intensity of red-blue light based on a specific algorithm, the purpose of optimizing supplementary lighting is achieved. In this embodiment, the spectral analysis component may adopt an AS7262 six-channel visible light multispectral sensor; the six visible channels include 450nm, 500nm, 550nm, 570nm, 600nm, and 650nm, each with a full width at half maxima (FWHM) of 40nm; thus, the first and sixth channels can be used to measure the intensity of blue and red light in the plant supplementary lighting lamp 14, respectively.

The plant supplementary lighting lamp 14 shown in this embodiment can be used both outdoors and in light-transmitting greenhouses and conservatories. To enable a single plant supplementary lighting lamp 14 to uniformly cover a large area of crops, the plant supplementary lighting lamp 14 needs to be installed at a height of several meters above the ground; a wireless remote controller can provide great convenience for device switching, parameter adjustment, and other operations.

Compared with existing LED plant supplementary lighting lamps 14, this embodiment uses monochromatic light sources (lasers) operating in a low-duty-cycle repetitive pulse mode; this not only can more effectively increase the photosynthesis rate of plants 15 than continuous broad-spectrum LED supplementary lighting lamps, but also significantly reduce the power consumption of the supplementary lighting lamp itself; moreover, it does not require mains power supply and can perform all-weather supplementary lighting solely by solar power supply (including a built-in lithium battery); it can not only provide day and night supplementary lighting on sunny days but also work continuously for several days on cloudy and rainy days; this not only saves mains electricity costs but also avoids the need to erect power supply grids.

Referring to Fig. 4, in some embodiments, the light source component further includes a plurality of driving circuits configured to drive different light sources to generate lasers of a plurality of wavelength bands; one of the driving circuits is denoted as a first driving circuit 104, and/or another is denoted as a second driving circuit 105; the first driving circuit 104 is electrically connected to the first light source 102 and the control device 106, and is configured to adjust the operating parameters of the first light source 102 based on a first operation command of the control device 106 to regulate the pulse amplitude of the first wavelength band laser; the second driving circuit 105 is electrically connected to the second light source 103 and the control device 106, and is configured to adjust the operating parameters of the second light source 103 based on a second operation command of the control device 106 to regulate the pulse amplitude of the second wavelength band laser; the first operation command and the second operation command are generated based on the second ratio value.

Continuous light with a constant amplitude is not optimal for promoting the photosynthesis of plants 15, while repetitive light pulses at a certain frequency can effectively increase the rate of photosynthesis and significantly reduce the power consumption of the plant supplementary lighting lamp 14 itself. The photosynthesis process of plants 15 first undergoes light reactions, followed by dark reactions; the speed of light reactions is on the microsecond scale, and the speed of dark reactions is on the millisecond scale; therefore, pulsed lasers can be used to promote the photosynthesis of plants 15 while achieving the goal of further energy saving.

Based on this, this embodiment adds a driving circuit electrically, which is connected to the light source and is a semiconductor laser pulse driving circuit; the driving circuit can drive the light source to generate repetitive pulse lasers with a certain amplitude, frequency, and pulse width; the repetitive pulse lasers can increase the photosynthesis rate of plants 15 while reducing the energy consumption of the light source. Correspondingly, the driving circuit includes the first driving circuit 104 and the second driving circuit 105; the first driving circuit 104 is connected to the first light source 102, and the second driving circuit 105 is connected to the second light source 103. The control device 106 controls the first driving circuit 104 and the second driving circuit 105 respectively to adjust the first wavelength band laser and the second wavelength band laser.

Referring to Fig. 4, in some embodiments, the control component further includes a display device; the display device includes a first display 8 electrically connected to the control device 106 for displaying the operating parameters of the first light source 102; and/or the display device includes a second display 9 electrically connected to the control device 106 for displaying the operating parameters of the second light source 103.

The first display 8 and the second display 9 are disposed outside the base 120 and both electrically connected to the control device 106; the first display 8 is configured to display current information of the first wavelength band laser, including the wavelength range, amplitude, frequency, pulse, etc., of the first wavelength band laser; the second display 9 is configured to display current information of the second wavelength band laser, including the wavelength range, amplitude, frequency, pulse, etc., of the second wavelength band laser; this way, users can directly check the plant supplementary lighting lamp 14 of the supplementary lighting device.

Referring to Fig. 4, in some embodiments, the control component further includes a communication device 7 electrically connected to the control device 106; the communication device 7 is configured to send the operating parameters of the first light source 102 and the second light source 103 to a preset terminal 1300, and/or receive control instructions sent by the preset terminal 1300; the control device 106 is further configured to adjust the operating parameters of the first light source 102 and the second light source 103 based on the control instructions sent by the preset terminal 1300.

The communication device 7 varies according to the communication connection method in practical applications; for example, the communication device 7 may be an NB-IoT communication device, a Bluetooth communication device, a Star Flash communication device, a WIFI communication device, a 4G network standard communication device, or the like. The communication device 7 may also establish a connection with the preset terminal 1300 for communicating with the preset terminal 1300. For example, when the preset terminal 1300 is an infrared remote controller, the communication device 7 is an infrared sensing unit.

The communication device 7 is configured to collect plant-related data, which refers to the relevant information of plants 15 grown in the current plant planting area, including the type of plants 15, the current growth stage of plants 15, and the light intensity required by plants 15 at this growth stage; specifically, the light intensity refers to the wavelength range and light intensity of light waves corresponding to the highest photosynthesis efficiency of the plants 15.

In some embodiments, the preset terminal 1300 is one of a remote controller, a mobile phone, a tablet, and a computer. The preset terminal 130 may be a mobile phone, a tablet, a laptop computer, or the like, or an infrared remote controller, which is specifically adjusted according to actual needs.

In some embodiments, the supplementary lighting lamp further comprises a timer electrically connected to the control device 106, wherein the control device 106 is configured to adjust operating parameters of the first light source and the second light source based on a first time signal output by the timer. It should be noted that the timer is used to output a first time signal, which represents the current real-time time; the photosynthesis rate of plants 15 is different during the day and night, and the light intensity in the environment also differs; therefore, adding a timer facilitates the control device 106 to periodically adjust the first wavelength band laser and the second wavelength band laser based on the first time signal of the timer.

As a preferred embodiment, the plant supplementary lighting lamp 14 may further include a Power supply device 110 and a DC voltage stabilizing component 10; the Power supply device 110 may be a lithium battery, a lead-acid battery, a solar panel, or the like; preferably, the Power supply device 110 is a combination of a solar panel and a lithium battery (i.e., the solar panel has a built-in lithium battery); the Power supply device 110 shown in this embodiment is integrated with the plant supplementary lighting lamp 14, so it can perform all-weather supplementary lighting solely by solar power supply (including the built-in lithium battery); it can not only provide day and night supplementary lighting on sunny days but also work continuously for several days on cloudy and rainy days.

The adaptive laser plant supplementary lighting lamp based on spectral analysis of the invention can be powered by an AC power supply or a DC power supply. When the lamp is connected to an AC power supply, the DC voltage stabilizing component 10 can be used to convert AC power into DC power for the control device 106, the driving circuit, and the light source. When using the DC power supply, specifically, Fig. 5 shows a form where the Power supply device 110 is a solar panel; it should be noted that when the Power supply device 110 is a solar panel, the Power supply device 110 should be disposed outside the base 120 and facing south; preferably, the angle between the surface of the solar panel and the horizontal plane should correspond to the local latitude.

In some embodiments, the supplementary lighting lamp further comprises an insecticidal lamp and/or a pest repellent lamp 16 electrically connected to the control device 106, wherein the control device 106 is configured to control the on/off of the insecticidal lamp and/or the pest repellent lamp 16 based on a second time signal output by the timer. In this embodiment, the second time signal output by the timer may correspond to nighttime or periods with a high number of mosquitoes in summer; by adding the insecticidal lamp and/or the pest repellent lamp 16, it is convenient to further maintain the plants 15 in the plant planting area.

As a preferred embodiment, the control device 106 is further provided with a power monitoring function; considering the power consumption of the insecticidal lamp and/or the pest repellent lamp 16, the control device 106 can regularly measure the remaining power of the Power supply device 110; if the remaining power is enough, the insecticidal lamp and/or the pest repellent lamp 16 is turned on and works for a certain period of time; this way, the power management of the entire plant supplementary lighting lamp 14 can be further optimized, and energy consumption can be reduced.

In some embodiments, the supplementary lighting lamp further comprises a sensing component, comprising a temperature sensor electrically connected to the control device 106, wherein the temperature sensor is configured to collect an ambient temperature information, and the control device 106 is configured to adjust the operating parameter of the first light source 102 and the second source 103 based on the ambient temperature information; and/or the sensing component comprises a vision sensor electrically connected to the control device, the vision sensor is configured to collect a plant growth image of the plant planting area, and the control device 106 is configured to adjust the operating parameter of the first light source 102 and the second source 103 based on the plant growth image.

In this embodiment, the temperature sensor is configured to collect the ambient temperature information of the current plant planting area, which can be used to add a supplementary lighting restriction condition, that is, stopping supplementary lighting when the ambient temperature is lower than a certain value to avoid ineffective operation of the supplementary lighting lamp at low temperatures; the vision sensor is configured to collect the image information of the current plant planting area, extract the image data of plants 15 in the current plant planting area based on the image information, and determine the current growth stage of plants 15 based on the image data of plants 15.

As a specific embodiment for practical application, the rated voltage and current of the first light source 102 with 660nm is 1.9V/2.1A; the rated voltage and current of the second light source 103 with 450nm is 4.9V/2.1A. The first driving circuit 104 and the second driving circuit 105 are designed respectively for different volt-ampere characteristics, both operating at a frequency of 300Hz and a pulse width of 40µs; the output power intensity of the first light source 102 and the second light source 103 is adjustable in 0-9 gears (0 gear: no output; 1-9 gears: intensity increases sequentially). The infrared remote controller (i.e., the preset terminal 130) includes 5 functions: Red Light +, Red Light -, Blue Light +, Blue Light -, and On/Off; the functions are intuitive, enabling adjustment of red and blue light intensity and standby mode. The plant supplementary lighting lamp 14 is installed on a fixed frame 3 meters above the ground, and the remote control distance of the remote controller is not less than 6 meters.

The power consumption estimation process of the entire plant supplementary lighting lamp 14 is as follows: calculating at an operating frequency of 300Hz and a pulse width of 40µs, the cumulative light emission time per second is 300×40µs=12000µs, which is equivalent to 1.2% of the continuous light emission mode; the overall power consumption is much lower than that of ordinary LED supplementary lighting lamps. The solar photovoltaic module (i.e., the Power supply device 110) used in this embodiment has a model of 140W/70Ah; the photovoltaic panel has an operating voltage of 15-18V and a peak output power of up to 140W; the built-in lithium battery has an output voltage of 12V and a capacity of 70Ah. The average power consumption of the supplementary lighting lamp during operation is only 4.08W (12V 0.34A); without light, the 70Ah lithium battery can power a single supplementary lighting lamp for 70Ah/0.34A≈205h, about 8.5 days.

Further, the plant supplementary lighting lamp 14 also includes a 4G network camera for monitoring plant growth; the 4G network camera can be connected to the user's preset terminal 130 by the communication device, facilitating real-time transmission of plant growth status to the preset terminal 130 for user monitoring; combined with the centralized display of plant growth data on the preset terminal 130, users can directly adjust the lighting mode of the plant supplementary lighting lamp on the preset terminal 130.

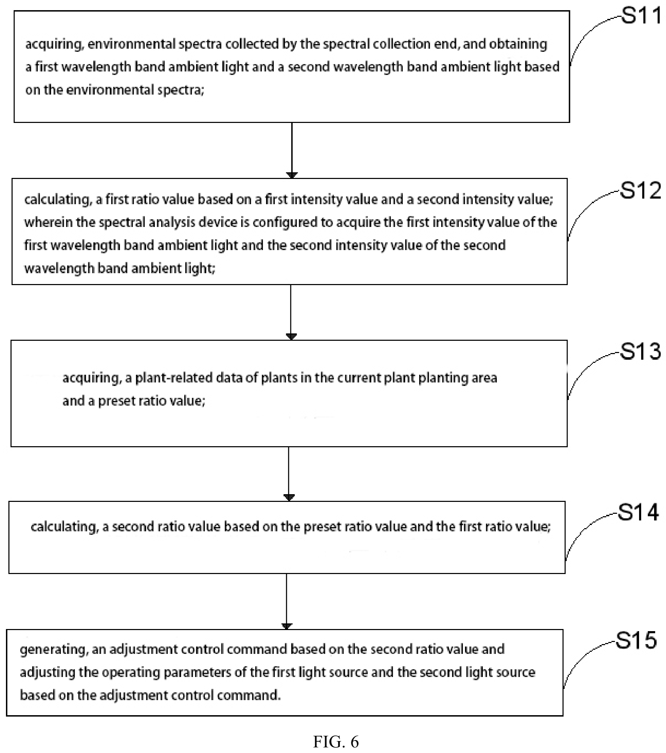

Referring to Fig. 6, in a fifth aspect, this embodiment further provides an adaptive laser plant supplementary lighting method, being applicable to the adaptive laser plant supplementary lighting lamp according to the fourth aspect; the method includes the following steps:
S11: acquiring environmental spectra collected by the spectral collection end, and obtaining a first wavelength band ambient light and a second wavelength band ambient light based on the environmental spectra;
S12: calculating a first ratio value based on a first intensity value and a second intensity value; wherein the spectral analysis device is configured to acquire the first intensity value of the first wavelength band ambient light and the second intensity value of the second wavelength band ambient light;
S13: acquiring plant-related data of plants in the current plant planting area and a preset ratio value, wherein the preset ratio value is a ratio between the light intensity of the first wavelength band and the light intensity of the second wavelength band required by the plants in the current plant planting area during the growth stage;
S14: calculating a second ratio value based on the preset ratio value and the first ratio value, wherein the plant-related data includes the current growth cycle and/or growth habits of the plants, and the second ratio value is a ratio between the intensity value of the first wavelength band laser and the intensity value of the second wavelength band laser; and
S15: generating an adjustment control command based on the second ratio value, and adjusting the operating parameters of the first light source and the second light source based on the adjustment control command, wherein the operating parameters of the first light source and the second light source include a third intensity value of the first wavelength band laser and a fourth intensity value of the second wavelength band laser.

In this embodiment, the environmental spectra include the first wavelength band ambient light and the second wavelength band ambient light; the first wavelength band ambient light corresponds to the first intensity value, and the second wavelength band ambient light corresponds to the second intensity value; and a first ratio is calculated based on the first intensity value and the second intensity value. In this embodiment, the first ratio value = the first intensity value : the second intensity value.

In this embodiment, the plant-related data includes the growth type, growth habits, and growth status of the currently planted plants; the growth type of currently planted plants can be understood as the category of the plants; the growth habits can be understood as various information of this category of plants during growth, including requirements for ambient temperature and humidity, and the light intensity required for the highest photosynthetic efficiency at different growth stages; for ease of understanding, the light required for the highest photosynthetic efficiency at different growth stages is denoted as "growth light"; the growth status can be understood as the real-time growth state of the currently planted plants; for example, the growth habits include temperature and humidity requirements, and the light intensity required for photosynthesis corresponding to the seedling stage, seedling establishment stage, growth stage, flowering stage, and fruiting stage of the plants; the growth status refers to the current growth stage of the plants (i.e., one of the seedling stage, seedling establishment stage, growth stage, flowering stage, and fruiting stage). Specifically, the preset ratio value is a ratio between the light intensity of the first wavelength band and the light intensity of the second wavelength band required by the current plants during the growth stage.

In this embodiment, the third intensity value is the light intensity of the first wavelength band laser corresponding to the second ratio value, and the fourth intensity value is the light intensity of the second wavelength band laser corresponding to the second ratio value.

The control device may pre-acquire the preset ratio value between the first wavelength band light and the second wavelength band light required by the current plants at their current growth stage; then, combined with the first ratio value corresponding to the existing ambient light, calculations can be performed to obtain the second ratio value corresponding to the first wavelength band laser and the second wavelength band laser, and the operating parameters of the first light source and the second light source are adjusted based on the second ratio value. For ease of description, the light in the first wavelength band and the second wavelength band are abbreviated as red-blue light. For example, for a certain crop, the desired intensity ratio of red-blue light irradiation is 5M:1M (where M is the optical power per unit area); if the actual measured ratio of red-blue light in the ambient light is 2.5M:0.5M, the supplementary lighting lamp needs to output red-blue light at an intensity ratio of 2.5M:0.5M.

This embodiment adjusts the operating parameters of the first light source and the second light source based on the environmental spectra within the preset wavelength band range in the ambient light collected by the spectral collection end, thereby realizing the intensity adjustment of the first light source and the second light source; this achieves the effect of automatically adjusting the light intensity of the plant supplementary lighting lamp based on the ambient light, ensuring that the light intensity within the preset wavelength band range in the environment where the plants are located is maintained, which is conducive to plant growth.

In a sixth aspect, this embodiment further provides a computer-readable storage medium storing computer program instructions, when computer program instructions are executed by a processor, implement the method according to the fifth aspect.

In the above-mentioned technical solution, the plant supplementary lighting lamp 14 is disposed in a plant planting area and includes a base 120, and a light source component, a light homogenizing component, a control component, and a spectral analysis component disposed on the base 120; the light source component comprises a first light source 102 and a second light source 103; the first light source 102 is configured to emit a first wavelength band laser, and the second light source 103 is configured to emit a second wavelength band laser; the spectral analysis component comprises a spectral collection end and a spectral analysis device, and the spectral collection end electrically connected to the spectral analysis device and arranged facing the external environment; the spectral collection end is configured to collect environmental spectra within a preset wavelength band range in ambient light, where the environmental spectra include a first wavelength band ambient light and a second wavelength band ambient light; the spectral analysis device is configured to calculate a first ratio value between the first wavelength band ambient light and the second wavelength band ambient light; the control component includes a control device 106 electrically connected to the first light source 102, the second light source 103, the spectral analysis device, and the spectral collection end; the control device 106 is configured to calculate a second ratio value between the first wavelength band laser and the second wavelength band laser based on the first ratio value, and adjust the operating parameters of the first light source 102 and the second light source 103 based on the second ratio value. This technical solution can adjust the operating parameters of the first light source 102 and the second light source 103 based on the environmental spectra within the preset wavelength band range in the ambient light collected by the spectral collection end, thereby realizing the intensity adjustment of the first light source 102 and the second light source 103; this achieves the effect of automatically adjusting the light intensity of the plant supplementary lighting lamp 14 based on the ambient light, ensuring that the light intensity within the preset wavelength band range in the environment where the plants are located is maintained, which is conducive to plant growth.

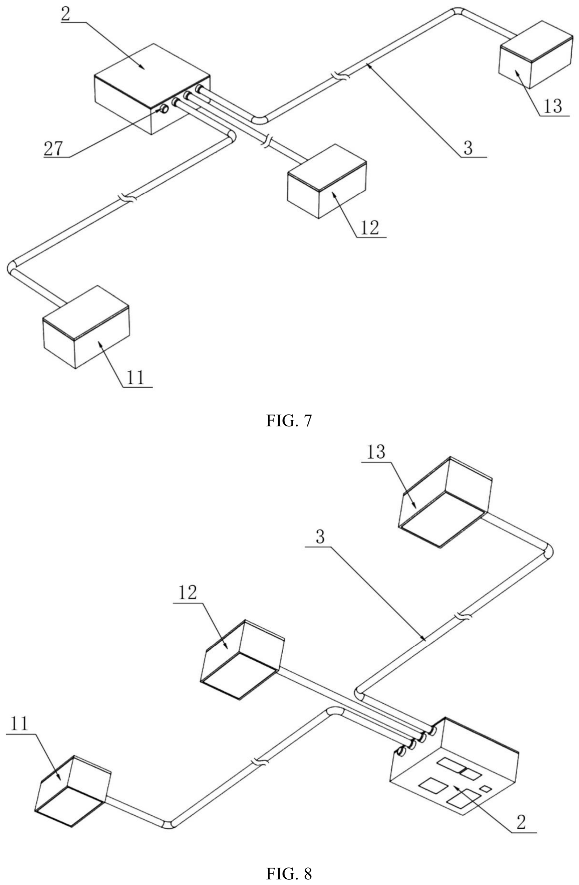

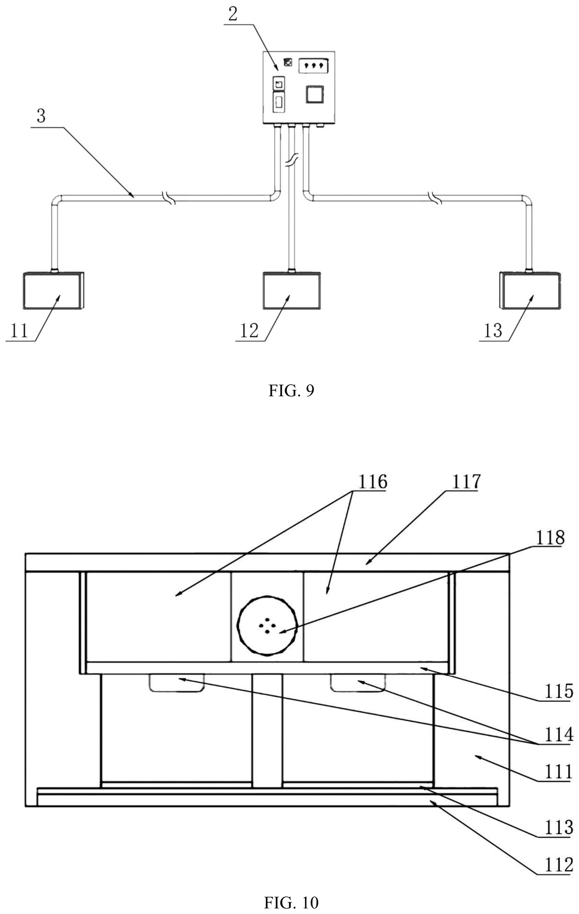

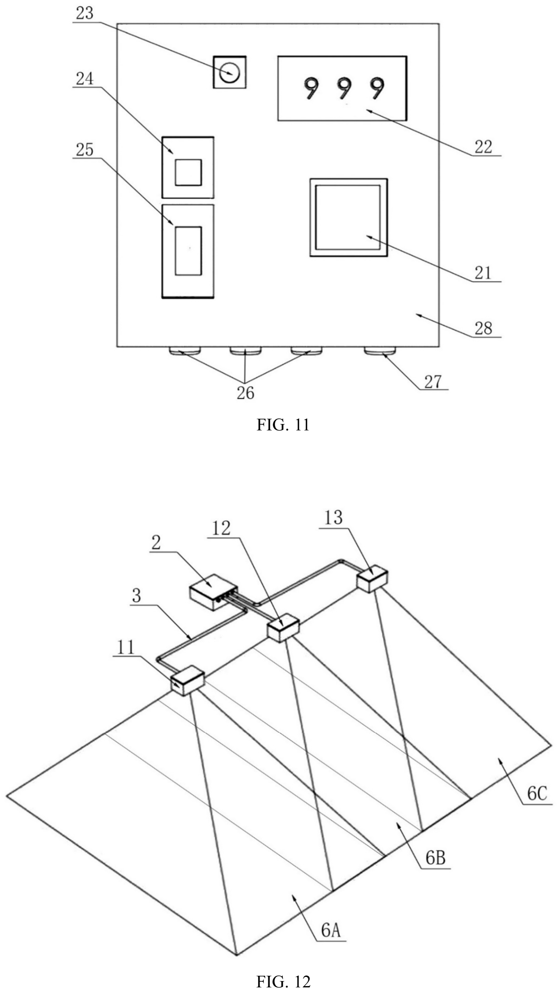

In a seventh aspect, referring to Figs. 7 to 11, this embodiment further provides a distributed laser plant supplementary lighting device, comprising: a laser device group, an intelligent controller, and a connecting cable.

The laser device group is provided with at least 2 laser devices; the technical solution of the present embodiment is provided with 3 laser devices.

The laser device group includes a first laser device 11, a second laser device 12, and a third laser device 13; the first laser device 11, the second laser device 12, and the third laser device 13 have the same structure.

The connecting cables 3 are multi-core cables; the number of connecting cables 3 is the same as the number of laser devices.

The first laser device 11, the second laser device 12, and the third laser device 13 are respectively electrically connected to the intelligent controller 2 by one connecting cable 3.

The first laser device 11 includes a laser device housing 111, a light exit panel 112, a light homogenizing lens array 113, a semiconductor laser 114, a heat sink-based circuit board 115, a laser radiator 116, a heat dissipation backplane 117, and a laser device cable connector 118.

The light exit panel 112 is disposed on a lower end surface of the laser device housing 111; the light homogenizing lens array 113 is disposed above the light exit panel 112; the semiconductor laser 114 is disposed above the light homogenizing lens array 113; the lower surface of the heat sink-based circuit board 115 is attached to the semiconductor laser 114; the laser radiator 116 is fixed on the heat sink-based circuit board 115; the heat dissipation backplane 117 is fixed on a top end of the laser device housing 111; the laser device cable connector 118 is disposed on an outer end surface of one side of the laser device housing 111; the laser device cable connector 118 is electrically connected to the semiconductor laser 114; that is, the light exit panel 112, the light homogenizing lens array 113, the semiconductor laser 114, the heat sink-based circuit board 115, the laser radiator 116, and the heat dissipation backplane 117 are sequentially stacked in the laser device housing 111 from bottom to top; the semiconductor laser 114 is closely attached to the laser radiator 116 by the heat sink-based circuit board 115.

The light exit panel 112 is resin or glass to ensure high laser transmittance and serves as a sealing component to ensure the waterproof function of the first laser device.

The light homogenizing lens array 113 transmits and shapes the laser beam emitted by the semiconductor laser 114 to obtain a rectangular laser beam; the light homogenizing lens array 113 is a free-form surface lens array (curvature 0.65-2.36), which increases the divergence angle of the laser to 60-120°.

The emission wavelength range of the semiconductor laser 114 is 400-1000 nm.

The laser device cable connector 118 is a multi-core cable waterproof connector.

The intelligent controller 2 includes a communication component 21, an information display screen 22, a light intensity detector 23, a temperature detector 24, a gas composition detector 25, a cable interface 26, a power supply access port 27, a main control board, and a controller housing 28.

The communication component 21, the information display screen 22, the light intensity detector 23, the temperature detector 24, and the gas composition detector 25 are disposed below the controller housing 28; the main control board is disposed in the controller housing 28; a plurality of cable interfaces 26 are provided, and the number of cable interfaces 26 is the same as the number of laser devices; the plurality of cable interfaces 26 and the power supply access port 27 are disposed on one side of the controller housing 28; the communication component 21, the information display screen 22, the light intensity detector 23, the temperature detector 24, the gas composition detector 25, the cable interfaces 26, the power supply access port 27, and the main control board are electrically connected.

The communication component 21 is responsible for information transmission and intelligent control with the main communication equipment of the entire agricultural production base.

The information such as light intensity, temperature, gas types and concentrations in the air collected by the light intensity detector 23, the temperature detector 24, and the gas composition detector 25 is transmitted to the main communication equipment of the agricultural production base by the communication component 21; the signal transmission frequency can be selected as real-time or timed transmission; then, the main communication equipment of the agricultural production base uploads the information to the cloud database, and simultaneously receives control signals from the cloud to adjust parameters such as the spectrum and light intensity of the laser.

The information such as light intensity, temperature, gas types and concentrations in the air collected by the light intensity detector 23, the temperature detector 24, and the gas composition detector 25 is displayed in real time by the information display screen 22.

Referring to Figs. 7 to 12, this embodiment further provides a distributed laser plant supplementary lighting device, comprising: a laser device group, an intelligent controller, and a connecting cable.

The laser device group includes a first laser device 11, a second laser device 12, and a third laser device 13; the first laser device 11, the second laser device 12, and the third laser device 13 have the same structure.

The first laser device 11, the second laser device 12, and the third laser device 13 are arranged at equal intervals along the same axis.

The connecting cables 3 are multi-core cables; three connecting cables 3 are provided, and the intelligent controller 2 is respectively electrically connected to the first laser device 11, the second laser device 12, and the third laser device 13 by the three connecting cables 3.

The first laser device 11 projects a first rectangular laser beam field 6A downward, the second laser device 12 projects a second rectangular laser beam field 6B downward, and the third laser device 13 projects a third rectangular laser beam field 6C downward; the first rectangular laser beam field 6A, the second rectangular laser beam field 6B, and the third rectangular laser beam field 6C form a light overlapping rectangular light field.

The irradiation area of the light field is 120-240 square meters; when rectangular laser beams projected by more than 2 laser devices are overlapped, the light field energy is ≥0.1µmol/m²/s.

According to field tests, when the laser energy received by plants exceeds 0.1µmol/m²/s, the photosynthetic carriers in the plants will form a periodic arrangement, which improves the absorption coefficient of sunlight, enhances the photosynthesis of plants, and thereby increases yield and quality.

It should also be noted that in the specification, relational terms such as "first" and "second" are only used to distinguish one entity or operation from another entity or operation, and do not necessarily require or imply any such actual relationship or order between these entities or operations. Furthermore, the terms "comprise", "include", or any other variation thereof are intended to cover a non-exclusive inclusion, such that a process, method, item, or device that comprises a list of elements not only includes those elements but also includes other elements not explicitly listed, or includes elements inherent to such a process, method, item, or device. Without further limitations, an element defined by the phrase "comprising a..." does not exclude the presence of additional identical elements in the process, method, item, or device that comprises the element.

The various embodiments in the specification are described in a progressive manner, and each embodiment focuses on the differences from other embodiments; for the same and similar parts between the various embodiments, reference can be made to each other.

The above-mentioned description of the disclosed embodiments enables those skilled in the art to implement or use the invention. The various modifications to these embodiments will be obvious to those skilled in the art, and the general principles defined herein can be implemented in other embodiments without departing from the spirit or scope of the invention. Therefore, the invention will not be limited to the embodiments shown herein, but is to be accorded the widest scope consistent with the principles and novel features disclosed herein.

## Claims

1. A laser plant regulation apparatus, comprising:
a base, including an accommodating cavity and a light through-hole, wherein the light through-hole is in communication with the accommodating cavity;
a light homogenizing member, disposed at the light through-hole;
a control device;
a light source, disposed in the accommodating cavity, wherein an output end of the light source is configured to toward the light homogenizing member, the light source is configured to output a plurality of lasers with different wavelength bands;
a driving circuit, disposed in the accommodating cavity and electrically connected to the light source and the control device, respectively, wherein the driving circuit is configured to adjust a relevant parameter of the light source based on a control command from the control device;
a communication device, disposed in the accommodating cavity and electrically connected to the control device, wherein the communication device is configured to establish a communication connection with a server to obtain plant-related information; and
a sensing component, disposed in the accommodating cavity and electrically connected to the control device, wherein the sensing component is configured to collect environmental parameter information;
wherein the control command of the control device includes an operating parameter of the light source, wherein the operating parameter is generated based on the plant-related information and/or the environmental parameter information.

2. The laser plant regulation apparatus according to claim 1, wherein the light source comprises a first light source and a second light source arranged in parallel; the plurality of lasers with different wavelength bands include a first wavelength band laser and a second wavelength band laser; the first light source is configured to output the first wavelength band laser, and the second light source is configured to output the second wavelength band laser;
Wherein the driving circuit is configured to drive different light sources to generate lasers of a plurality of wavelength bands.

3. The laser plant regulation apparatus according to claim 1, wherein the sensing component comprises at least one of a temperature sensor, a humidity sensor, a vision sensor, a spectral sensor, and a timer.

4. A laser plant regulation method, being applicable to the laser plant regulation apparatus according to any one of claims 1 to 3, wherein the light source comprises a first light source and a second light source arranged in parallel; the plurality of lasers with different wavelength bands include a first wavelength band laser and a second wavelength band laser; the first light source is configured to output the first wavelength band laser, and the second light source is configured to output the second wavelength band laser; the driving circuit is configured to drive different light sources to generate lasers of a plurality of wavelength bands;
the method comprises:
acquiring, environmental parameter information and plant-related information, wherein the environmental parameter information includes at least one of a temperature information, humidity information, light information, and time information; the plant-related information includes a growth type, a growth habit, and a growth status of currently planted plant;
generating, a first reference light intensity information based on the environmental parameter information, and generating, a second reference light intensity information based on the plant-related information and the environmental parameter information;
generating, an operating parameter of the light source based on the first reference light intensity information and the second reference light intensity information; and
controlling, the driving circuit to adjust a relevant parameter of the light source based on the operating parameter.

5. The laser plant regulation method according to claim 4, wherein the first reference light intensity information includes an intensity variation value of an ambient light within a preset period; the second reference light intensity information includes an intensity variation value of a growth light within a preset period; the environmental parameter information includes time information;
Wherein generating, an operating parameter of the light source based on the first reference light intensity information and the second reference light intensity information, comprises:
obtaining, an intensity value of the ambient light in a current first reference light intensity information based on the current time information, and obtaining, an intensity value of the growth light in a current second reference light intensity information based on the current time information;
calculating, a difference between the intensity value of the ambient light and the intensity value of the growth light;
generating, an intensity value of the first wavelength band laser and an intensity value of the second wavelength band laser based on the difference; and
calculating, an operating parameter of the lasers with different wavelength bands of the light source based on the intensity value of the first wavelength band laser and the intensity value of the second wavelength band laser.

6. The laser plant regulation method according to claim 5, wherein the sensing component comprises at least one of a temperature sensor, a humidity sensor, a vision sensor, a spectral sensor, and a timer; the environmental parameter information includes temperature information and humidity information;
wherein generating, a second reference light intensity information based on the plant-related information and the environmental parameter information, comprises:
acquiring, a plant-related information, and generating, a first growth light reference value of a current plant in a current growth stage based on the plant-related information;
acquiring, current vision sensor information, current timer information, current temperature information, and current humidity information, and generating, a second growth light reference value of the plant in the current growth stage based on the current vision sensor information, the current timer information, the current temperature information, and the current humidity information; and
generating, a second reference light intensity information based on the first growth light reference value and the second growth light reference value.

7. An adaptive laser plant supplementary lighting lamp based on spectral analysis, disposed in a plant planting area, comprising a base, and a light source component, a light homogenizing component, a control component, and a spectral analysis component disposed on the base;
wherein the light source component comprises a plurality of light sources arranged in parallel, wherein the plurality of light sources emit lasers with different wavelength bands;
wherein the light homogenizing component comprises a light homogenizing member disposed at an output end of each light source, wherein the light homogenizing member is configured to homogenize the lasers with different wavelength bands and then project the lasers to the plant planting area;
wherein the spectral analysis component comprises a spectral collection end and a spectral analysis device, wherein the spectral collection end is electrically connected to the spectral analysis device and arranged facing an external environment; the spectral collection end is configured to collect an environmental spectra within a preset wavelength band range in ambient light, wherein the environmental spectra include an ambient light with different wavelength bands; the spectral analysis device is configured to calculate a first ratio value of the ambient light with different wavelength bands;
wherein the control component comprises a control device electrically connected to the plurality of light sources and the spectral collection end, wherein the control device is configured to calculate a second ratio value of the lasers with different wavelength bands based on the first ratio value, and adjust an operating parameter of the first light source and the second light source based on the second ratio value.

8. The adaptive laser plant supplementary lighting lamp based on spectral analysis according to claim 7, wherein the control component further comprises:
a communication device, electrically connected to the control device and configured to send the operating parameter of the plurality of light sources to a preset terminal, and/or receive a control instruction sent by the preset terminal; the control device is further configured to adjust the operating parameter of the plurality of light sources based on the control instruction sent by the preset terminal.

9. The adaptive laser plant supplementary lighting lamp based on spectral analysis according to claim 7, comprising:
a sensing component, comprising a temperature sensor electrically connected to the control device, wherein the temperature sensor is configured to collect an ambient temperature information, and the control device is configured to adjust the operating parameter of the plurality of light sources based on the ambient temperature information; and/or the sensing component comprises a vision sensor electrically connected to the control device, the vision sensor is configured to collect a plant growth image of the plant planting area, and the control device is configured to adjust the operating parameter of the plurality of light sources based on the plant growth image.

10. A distributed laser plant supplementary lighting device, comprising: a laser device group, an intelligent controller, and a connecting cable;
wherein the laser device group is provided with a plurality of laser devices with a same structure;
wherein the laser device comprises a laser device housing, a light exit panel, a light homogenizing lens array, a semiconductor laser, and a laser device cable connector; the light exit panel, the light homogenizing lens array, and the semiconductor laser are sequentially stacked in the laser device housing from bottom to top, and the light exit panel is disposed on a lower end face of the laser device housing; the semiconductor laser is electrically connected to the laser device cable connector;
wherein the plurality of laser devices with the same structure are respectively electrically connected to the intelligent controller through connecting cables; the plurality of laser devices with the same structure are arranged at equal intervals along a same axis, each laser device projects a rectangular laser beam, and a plurality of rectangular laser beams form an overlapping rectangular light field.

11. The distributed laser plant supplementary lighting device according to claim 10, wherein the laser device is further provided with a heat sink-based circuit board, a laser radiator, and a heat dissipation backplane; the semiconductor laser is closely attached to the laser radiator through the heat sink-based circuit board; the heat dissipation backplane is fixed on a top of the laser device housing.

12. The distributed laser plant supplementary lighting device according to claim 10, wherein the intelligent controller comprises a communication component, an information display screen, a light intensity detector, a temperature detector, a gas composition detector, a cable interface, a power supply access port, a main control board, and a controller housing;
the communication component, the information display screen, the light intensity detector, the temperature detector, and the gas composition detector are disposed below the controller housing;
the main control board is disposed in the controller housing;
the number of cable interfaces is the same as the number of laser devices;
the plurality of cable interfaces and the power supply access port are disposed on one side of the controller housing; and
the communication component, the information display screen, the light intensity detector, the temperature detector, the gas composition detector, the cable interface, the power supply access port, and the main control board are electrically connected.

13. The distributed laser plant supplementary lighting device according to claim 12, wherein information collected by the light intensity detector, the temperature detector, and the gas composition detector is displayed in real time by the information display screen.

14. The distributed laser plant supplementary lighting device according to claim 10, wherein a laser beam emitted by the semiconductor laser is transmitted and shaped by the light homogenizing lens array to obtain a rectangular laser beam.

15. The distributed laser plant supplementary lighting device according to claim 14, wherein the light homogenizing lens array is a free-form surface lens array, and a curvature range of the free-form surface lens is 0.65-2.36.

16. The distributed laser plant supplementary lighting device according to claim 10, wherein an energy of the overlapping rectangular light field formed by the plurality of rectangular laser beams is ≥0.1µmol/m²/s.
